# DEMANDE DE BREVET EUROPEEN

(11) **EP 3 671 231 A1**
(43) Date de publication de la demande: **24.06.2020**
(21) Numéro de dépôt: 19218029.7
(22) Date de dépôt: 19.12.2019
(51) Int. Cl.: G01R 21/133, G01R 22/06, G01R 19/25

(54) **PROCÉDÉ ET SYSTÈME DE MESURE DE GRANDEURS ÉLECTRIQUES**

(30) Priorité: 20.12.2018 FR 1873633
(71) Demandeur: Schneider Electric Industries SAS, 92500 Rueil Malmaison (FR)
(72) Inventeur: GUIBERT, Philippe, 38050 GRENOBLE CEDEX 09 (FR); HENRY, Gilles, 38050 GRENOBLE CEDEX 09 (FR)
(74) Mandataire: Lavoix

(57) **Abrégé**

Ce procédé de mesure de grandeurs électriques comporte :
- l'envoi d'un message de synchronisation (66) sur un bus de données, par un module de synchronisation connecté au bus de données, l'envoi étant réalisé avec une période d'émission (T_{com}) décomptée à l'aide d'une première horloge du module de synchronisation ;
- la réception du message de synchronisation, par des modules de mesure connectés au bus de données, chaque module de mesure comportant une deuxième horloge et un capteur adapté pour mesurer une grandeur électrique ;
- le décompte, par chaque module de mesure ayant reçu le message de synchronisation, d'une première durée d'attente (t₁), le décompte étant réalisé, pour chacun desdits modules de mesure, en utilisant sa deuxième horloge (48) ;
- pour chacun desdits modules de mesure, la mesure de la grandeur électrique au moyen du capteur correspondant à la fin du décompte de la première durée d'attente (t₁).

## Description

L'invention se rapporte à un procédé de mesure de grandeurs électriques et à un système de mesure de grandeurs électriques.

Dans le domaine de l'instrumentation industrielle, il existe des capteurs destinés à mesurer des grandeurs électriques au sein d'installations électriques, telles que des réseaux de distribution d'électricité. Les grandeurs électriques mesurées par les capteurs peuvent être utilisées pour contrôler et superviser l'installation électrique. Dans certaines applications, il est nécessaire que les mesures de certaines grandeurs électriques soient réalisées simultanément par tous les capteurs.

Par exemple, des capteurs sont associés à des conducteurs électriques d'une installation électrique distribuant un courant électrique alternatif. Différentes grandeurs électriques, telles que la tension électrique entre deux conducteurs électriques, ou l'intensité d'un courant électrique circulant dans un conducteur électrique, sont mesurées par des capteurs différents pouvant être placés à des emplacements différents de l'installation électrique. Les mesures sont réalisées à instants successifs au cours du temps. D'autres grandeurs électriques, notamment des valeurs de puissance électrique, sont ensuite calculées, pour les instants du temps correspondants, à partir des valeurs de courant et de tension mesurées.

Pour que les grandeurs électriques calculées soient précises, il est nécessaire que les grandeurs électriques mesurées associées à un même instant du temps soient mesurées simultanément ou quasi-simultanément par tous les capteurs.

Il est donc souhaitable de pouvoir synchroniser les mesures des capteurs de façon simple et fiable.

A cet effet, selon un aspect de l'invention, un procédé de mesure de grandeurs électriques comporte :
- l'envoi d'un message de synchronisation sur un bus de données, par un module de synchronisation connecté au bus de données, l'envoi étant réalisé avec une période d'émission, la période d'émission étant décomptée à l'aide d'une première horloge du module de synchronisation ;
- la réception du message de synchronisation, par des modules de mesure connectés au bus de données, chaque module de mesure comportant un capteur adapté pour mesurer une grandeur électrique, chaque module de mesure comportant également une unité électronique de traitement comprenant une deuxième horloge ;
- le décompte, par chaque module de mesure ayant reçu le message de synchronisation, d'une première durée d'attente, le décompte étant réalisé, pour chacun desdits modules de mesure, en utilisant la deuxième horloge appartenant à ce module de mesure ;
- pour chacun desdits modules de mesure, la mesure de la grandeur électrique au moyen du capteur correspondant à la fin du décompte de la première durée d'attente.

Selon des aspects avantageux mais non obligatoires, un tel procédé de mesure peut incorporer une ou plusieurs des caractéristiques suivantes, prises isolément ou suivant toute combinaison techniquement admissible :
- Le procédé comporte en outre, pour chacun desdits modules de mesure :
   - à la fin de la mesure de la grandeur électrique, le décompte d'une deuxième durée d'attente, en utilisant la deuxième horloge correspondante ;
   - mesurer à nouveau la grandeur électrique, lors d'une mesure additionnelle, au moyen du capteur correspondant, à la fin du décompte de la deuxième durée d'attente.
- Le procédé comporte en outre, pour chacun desdits modules de mesure, la mesure de l'intervalle de temps séparant la réception de deux messages de synchronisation consécutifs par ce module de mesure, cette mesure étant réalisée par le module de mesure en utilisant sa deuxième horloge, et la première durée d'attente est déterminée, pour ce module de mesure, en fonction dudit intervalle de temps précédemment mesuré par ce module de mesure.
- La première durée d'attente est déterminée, pour chacun desdits modules de mesure, suite à chaque réception d'un message de synchronisation par ce module de mesure, à partir d'une formule de calcul prédéterminée étant fonction de la valeur dudit intervalle de temps précédemment mesuré par ce module de mesure, par exemple dans laquelle la première durée d'attente est proportionnelle à ladite valeur dudit intervalle de temps en fonction d'un premier coefficient de proportionnalité prédéfini.
- Le procédé comporte la mesure de l'intervalle de temps séparant la réception de deux messages de synchronisation consécutifs par ce module de mesure, cette mesure étant réalisée par le module de mesure en utilisant sa deuxième horloge et la deuxième durée d'attente est déterminée, pour chacun desdits modules de mesure, en fonction dudit intervalle de temps précédemment mesuré par ce module de mesure.
- La deuxième durée d'attente est déterminée, pour chacun desdits modules de mesure, suite à chaque réception d'un message de synchronisation par ce module de mesure, à partir d'une formule de calcul prédéterminée étant fonction dudit intervalle de temps précédemment mesuré par ce module de mesure, par exemple dans laquelle la deuxième durée d'attente est proportionnelle à ladite valeur dudit intervalle de temps en fonction d'un deuxième coefficient de proportionnalité prédéfini.
- Les mesures additionnelles sont répétées par le module de mesure tant que le message de synchronisation suivant n'est pas reçu par le module de mesure.
   -- L'intervalle de temps mesuré n'est pas pris en compte par le module de mesure lorsque le nombre de mesures effectuées par ce module de mesure pendant cet intervalle de temps est différent d'un nombre prédéfini de mesures.
- L'envoi du message de synchronisation est réalisé périodiquement avec la période d'émission prédéfinie.
- L'envoi du message de synchronisation est réalisé avec un cycle d'émission de durée variable.
- Les modules de mesure sont associés à des conducteurs électriques d'une installation électrique, au moins un des modules de mesure étant configuré pour mesurer une tension électrique, au moins une pluralité des autres modules de mesure étant configurés pour mesurer une intensité d'un courant électrique.

D'autres aspects de l'invention concernent un système de mesure de grandeurs électriques, comportant :
- un module de synchronisation, comportant une première horloge ;
- des modules de mesure, chaque module de mesure comportant un capteur adapté pour mesurer une grandeur électrique, chaque module de mesure comportant également une deuxième horloge,
- un bus de données, le module de synchronisation et les modules de mesure étant connectés au bus de données,
dans lequel le module de synchronisation est configuré pour envoyer périodiquement un message de synchronisation sur le bus de données, avec une période d'émission prédéfinie, la période d'émission étant décomptée à l'aide de la première horloge ;
et dans lequel chaque module de mesure est configuré pour :
- recevoir des messages de synchronisation,
- après chaque réception d'un message de synchronisation, décompter une première durée d'attente, le décompte étant réalisé, pour chacun desdits modules de mesure, en utilisant la deuxième horloge appartenant à ce module de mesure ;
- mesurer la grandeur électrique au moyen du capteur correspondant à la fin du décompte de la première durée d'attente.

Selon des aspects avantageux mais non obligatoires, un tel système de mesure peut incorporer une ou plusieurs des caractéristiques suivantes, prises isolément ou suivant toute combinaison techniquement admissible :
- chaque module de mesure est en outre configuré pour, à la fin de la mesure de la grandeur électrique, décompter une deuxième durée d'attente, en utilisant la deuxième horloge correspondante, puis mesurer à nouveau la grandeur électrique, lors d'une mesure additionnelle, au moyen du capteur correspondant, à la fin du décompte de la deuxième durée d'attente.
- chaque module de mesure est en outre configuré pour répéter les mesures additionnelles tant que le message de synchronisation suivant n'est pas reçu par le module de mesure.

L'invention sera mieux comprise et d'autres avantages de celle-ci apparaîtront plus clairement à la lumière de la description qui va suivre d'un mode de réalisation d'un procédé de mesure et d'un système de mesure, donnés uniquement à titre d'exemple et faits en référence aux dessins annexés, dans lesquels :
[Fig 1] la figure 1 est une illustration schématique d'un système de mesure de grandeurs électriques selon un mode de mise en oeuvre de l'invention ;
[Fig 2] la figure 2 est une illustration schématique d'une installation électrique dans laquelle est installé le système de mesure de la figure 1 ;
[Fig 3] la figure 3 est une illustration schématique d'un module de synchronisation du système de mesure de la figure 1 ;
[Fig 4] la figure 4 est une illustration schématique d'un module de mesure du système de mesure de la figure 1 ;
[Fig 5] la figure 5 est un diagramme de flux d'un exemple d'un procédé de fonctionnement du module de synchronisation de la figure 3 ;
[Fig 6] la figure 6 est un chronogramme illustrant un exemple de fonctionnement du système de mesure de la figure 1 selon un premier mode de réalisation ;
[Fig 7] la figure 7 est un diagramme de flux d'un exemple d'un procédé de fonctionnement d'un module de mesure de la figure 4 selon le premier mode de réalisation ;
[Fig 8] la figure 8 est un chronogramme illustrant un exemple de fonctionnement du système de mesure de la figure 1 selon un deuxième mode de réalisation ;
[Fig 9] la figure 9 est un diagramme de flux d'un exemple d'un procédé de fonctionnement d'un module de mesure de la figure 4 selon le deuxième mode de réalisation ;
[Fig 10] la figure 10 est un diagramme de flux d'un exemple d'un procédé de fonctionnement du système de la figure 1 ;
[Fig 11] la figure 11 est un chronogramme illustrant un exemple de fonctionnement du système de mesure de la figure 1 selon un troisième mode de réalisation.

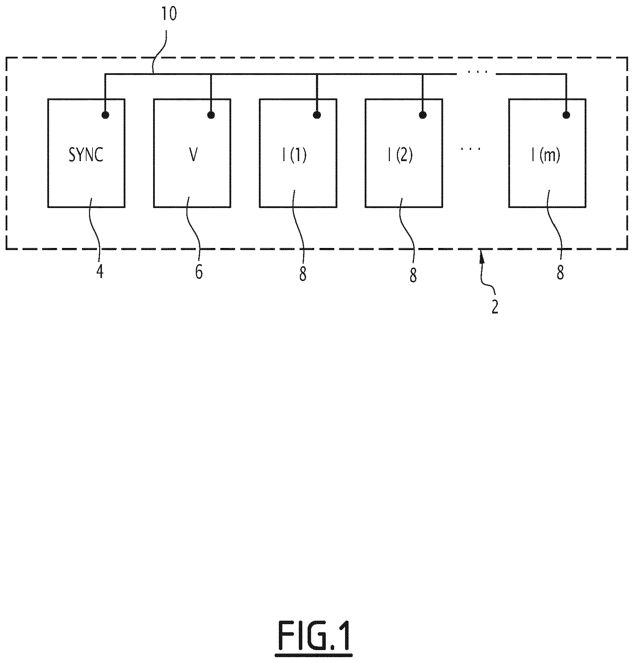

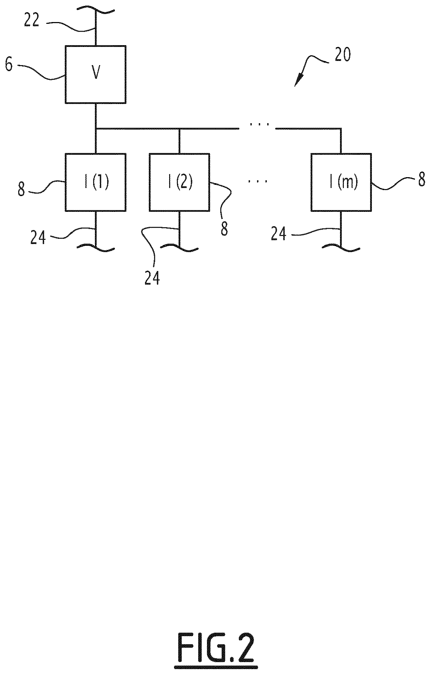

Les figures 1 et 2 représentent schématiquement un système de mesure 2 pour mesurer des grandeurs électriques.

Le système 2 est destiné à être associé à une installation électrique, telle qu'un réseau de distribution d'électricité, pour mesurer des grandeurs électriques au sein de cette installation électrique.

Le système 2 comporte un module de synchronisation 4, des modules de mesure 6 et 8 et un bus de données 10 auquel sont connectés le module de synchronisation 4 et les modules de mesure 6 et 8.

Chaque module de mesure 6, 8 comporte un capteur adapté pour mesurer une grandeur électrique. Selon des exemples, les grandeurs électriques peuvent être, de façon non exhaustive, des tensions électriques, ou des courants électriques. Les modules de mesure 6, 8 peuvent mesurer des grandeurs électriques différentes. Le capteur de chaque module de mesure 6 et 8 est donc choisi en conséquence.

Par exemple, lorsque le module de mesure est destiné à mesurer un courant électrique, le capteur est un capteur de courant, tel qu'un tore de Rogowski, ou un transformateur de courant, ou un capteur à effet Hall, ou un capteur de mesure par dérivation, aussi nommé « shunt ».

Lorsque le module de mesure est destiné à mesurer une tension électrique, le capteur est un capteur de tension, par exemple un shunt, ou un transformateur de tension, ou un capteur capacitif.

Dans les modes de réalisation illustrés, un premier module de mesure 6 est configuré pour mesurer une tension électrique et des deuxièmes modules de mesure 8 sont configurés pour mesurer une intensité d'un courant électrique.

Par exemple, le système 2 comporte un nombre « m » des deuxièmes modules de mesure 8, où « m » est un nombre entier supérieur ou égal à un. Pour simplifier les figures 1 et 2, seule une partie des deuxièmes modules de mesure 8 sont illustrés.

Selon un exemple illustratif et non nécessairement limitatif schématisé sur la figure 2, l'installation électrique 20 comporte une ligne primaire 22 et plusieurs lignes secondaires 24. La ligne primaire 22 est raccordée à une source électrique, telle qu'un générateur ou un transformateur de distribution, ou à un autre réseau électrique. Chaque ligne secondaire 24 raccorde la ligne primaire 22 à une unité cliente, comportant par exemple une charge électrique. D'autres configurations sont toutefois possibles.

Les capteurs respectifs des modules de mesure 6, 8 sont ici associés à des conducteurs électriques de l'installation électrique 20, par exemple, montés sur ou autour des conducteurs électriques formant les lignes 22, 24, pour mesurer une ou plusieurs grandeurs électriques relatives à ces lignes électriques 22, 24.

Dans l'exemple illustré, le premier module de mesure 6 est monté sur la ligne principale 22 pour mesurer une tension électrique V. Les deuxièmes modules de mesure 8 sont montés chacun sur une ligne secondaire 24 pour mesurer une intensité électrique I(1), I(2), ..., I(m). Pour simplifier la figure 2, le module de synchronisation 4 et le bus de connexion 10 ne sont pas illustrés.

D'autres exemples sont néanmoins possibles. Pour simplifier, on considère ici que l'installation 20 ne comporte qu'une phase électrique, mais les exemples décrits peuvent être généralisés à une installation électrique polyphasée pour laquelle chaque ligne 22, 24 comporte plusieurs phases électriques.

Le bus de données 10 permet aux modules 4, 6 et 8 d'échanger des données entre eux. Par exemple, le bus de données 10 inclut une liaison filaire qui forme une couche physique du bus de données 10. A titre d'exemple illustratif et non limitatif, le bus de données 10 est un bus de terrain, par exemple de type CAN, Modbus TCP ou MODBUS.

Dans l'exemple illustré, les modules 4, 6 et 8 sont connectés en série par le bus de données 10. En variante, toutefois, la topologie du bus de données 10 peut être différente et les modules 4, 6 et 8 peuvent être connectés par exemple selon une topologie en étoile, ou connectés en série deux à deux selon une topologie dite de type « daisy chain » en anglais.

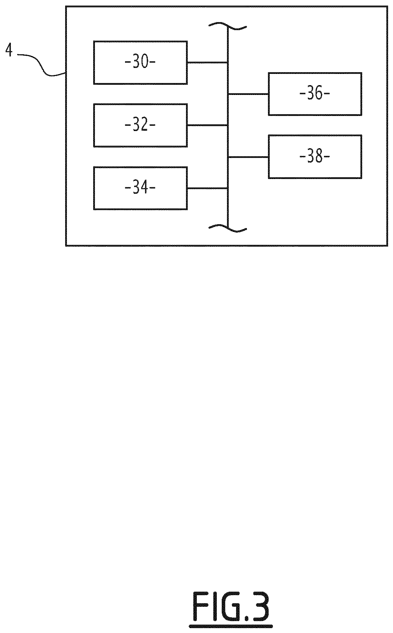

Comme illustré sur la figure 3, le module de synchronisation 4 comporte une unité logique de traitement 30 (« central processing unit » en anglais), une mémoire informatique 32, un support de stockage 34, une interface de communication 36 et une première horloge 38, ici connectés électriquement entre eux et implémentés par des circuits et composants électroniques.

Selon des exemples, l'unité logique 30 est un microprocesseur ou un microcontrôleur programmable. La mémoire 32 et le support 34 sont des mémoires par exemple à l'état solide, telle qu'une mémoire Flash, et forment chacune un support d'enregistrement de données non transitoire lisible par ordinateur.

L'interface de communication 36 est apte à être raccordée au bus 10 et comporte à cet effet un connecteur physiquement relié au bus 10 et un contrôleur programmé pour implémenter un protocole de communication prédéfini.

L'horloge 38 comporte un oscillateur électronique, par exemple un oscillateur à cristal, tel qu'un oscillateur à quartz. Par exemple, l'horloge 38 peut être intégrée à l'unité 30. L'horloge 38 peut être nommée « horloge principale ».

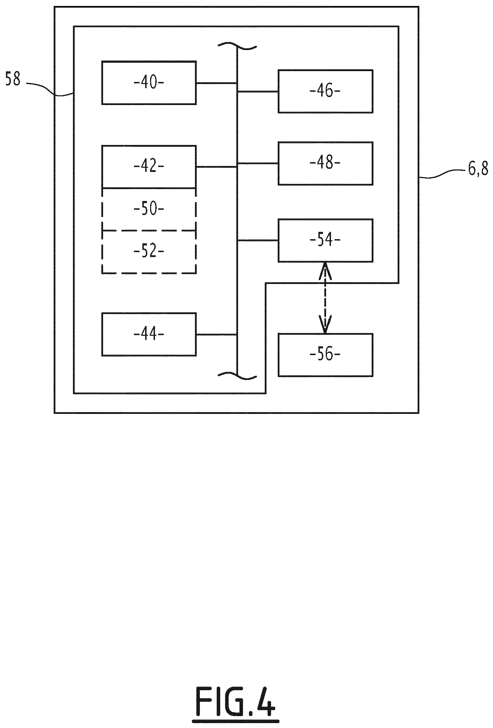

Comme illustré sur la figure 4, chaque module de mesure 6 et 8 comporte une unité logique de traitement 40, une mémoire informatique 42, un support de stockage 44, une interface de communication 46, qui sont par exemple analogues à l'unité logique 30, à la mémoire informatique 32, au support de stockage 34 et à l'interface de communication 36, respectivement.

Chaque module de mesure 6 et 8 comporte aussi :
- une deuxième horloge 48 pour implémenter un premier compteur 50 et un deuxième compteur 52,
- une interface 54 d'acquisition de mesures, et
- un capteur de mesure 56 tel que décrit précédemment et connecté à l'interface d'acquisition 54.

Par exemple, l'interface d'acquisition 54 comporte un convertisseur analogique-numérique et/ou un circuit de filtrage et/ou un circuit de traitement du signal.

Chaque deuxième horloge 48 comporte un oscillateur électronique, par exemple un oscillateur à cristal, tel qu'un oscillateur à quartz. Chaque deuxième horloge 48 peut être nommée « horloge locale ».

Les constituants de chaque module de mesure 6, 8 sont ici intégrés au sein d'une unité électronique 58 de commande qui peut être séparée du capteur 56.

Par exemple, les compteurs 50 et 52 sont chacun mis en oeuvre par l'unité 40 en décomptant une valeur de temps sur la base d'un signal de cadencement fourni par l'horloge 48. La valeur courante de chaque compteur 50 et 52 est stockée au moins temporairement dans la mémoire 42.

Selon des exemples, chaque deuxième horloge 48 peut avoir une précision moindre que la première horloge 38 et/ou être plus sujette à une dérive dans le temps que la première horloge 38.

Dans les exemples considérés, chaque module 4, 6, 8 est logé dans un appareil dédié, par exemple un appareil pourvu de son propre boîtier et, par exemple, de sa propre alimentation électrique.

Toutefois, selon des variantes non illustrées, différents modules 4, 6 et 8 peuvent être intégrés au sein d'un même appareil. Par exemple, le module de synchronisation 4 peut être intégré aux côtés d'un module de mesure 6 ou 8 dans un même appareil. Selon un autre exemple, un même appareil peut intégrer un module de mesure 6 et un module de mesure 8. Dans ce cas, les modules 6 et 8 peuvent partager le même circuit électronique 58, même si leurs capteurs 56 respectifs sont différents. Selon encore un autre exemple, un même appareil peut intégrer plusieurs modules de mesure 6 et/ou plusieurs modules de mesure 8, fonctionnant simultanément et indépendamment les uns des autres au sein de l'appareil afin d'assurer une redondance des mesures de la grandeur électrique.

En pratique, chaque mémoire 32, 42 et/ou chaque support 34, 44 stocke un code logiciel et/ou des instructions exécutables, lisibles, respectivement, par l'unité logique 30 ou 40 correspondante, pour mettre en œuvre automatiquement un ou plusieurs procédés selon l'un quelconque des modes de réalisation décrits et/ou envisagés ci-après.

Selon des variantes non illustrées, les modules 4, 6, 8 peuvent comporter un circuit électronique dédié, par exemple de type ASIC, ou un circuit logique reprogrammable, par exemple de type FPGA.

De façon générale, selon différents modes de réalisation, un procédé de mesure de grandeurs électriques mis en œuvre par le système 2 comporte :
- l'envoi d'un message de synchronisation sur le bus de données 10, par le module de synchronisation 4 connecté au bus de données 10, l'envoi étant réalisé avec une période d'émission T_{com} prédéfinie, la période d'émission étant décomptée à l'aide de la première horloge 38 du module de synchronisation 4 ;
- la réception du message de synchronisation, par les modules de mesure 6, 8 connectés au bus de données 10 ;
- le décompte, par chaque module de mesure 6, 8 ayant reçu le message de synchronisation, d'une première durée d'attente t₁, le décompte étant réalisé, pour chacun desdits modules de mesure 6, 8, en utilisant la deuxième horloge 48 appartenant à ce module de mesure ;
- pour chacun desdits modules de mesure 6, 8, la mesure de la grandeur électrique au moyen du capteur 56 correspondant, à la fin du décompte de la première durée d'attente.

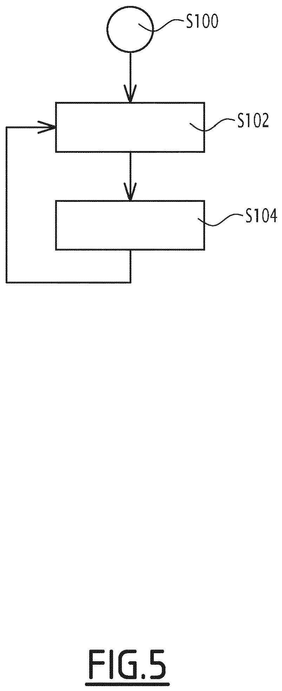

Des exemples de fonctionnement du système 2 selon des premiers modes de réalisation sont maintenant décrits en référence aux figures 5, 6 et 7.

Selon ces modes de mise en œuvre, le module de synchronisation 4 est donc programmé pour émettre périodiquement des messages de synchronisation sur le bus de données 10 avec la période d'émission T_{com}. Chaque message de synchronisation est envoyé à tous les modules de mesure 6 et 8 connectés au bus de données 10.

Par exemple, comme illustré sur la figure 5, après le début du procédé (étape S100), le module de synchronisation 4 émet un message de synchronisation sur le bus 10 (étape S102) puis attend jusqu'à la fin de la période d'émission T_{com} (étape S104) avant d'émettre à nouveau un message de synchronisation, les étapes d'émission S102 et d'attente S104 étant répétées jusqu'à l'arrêt du procédé.

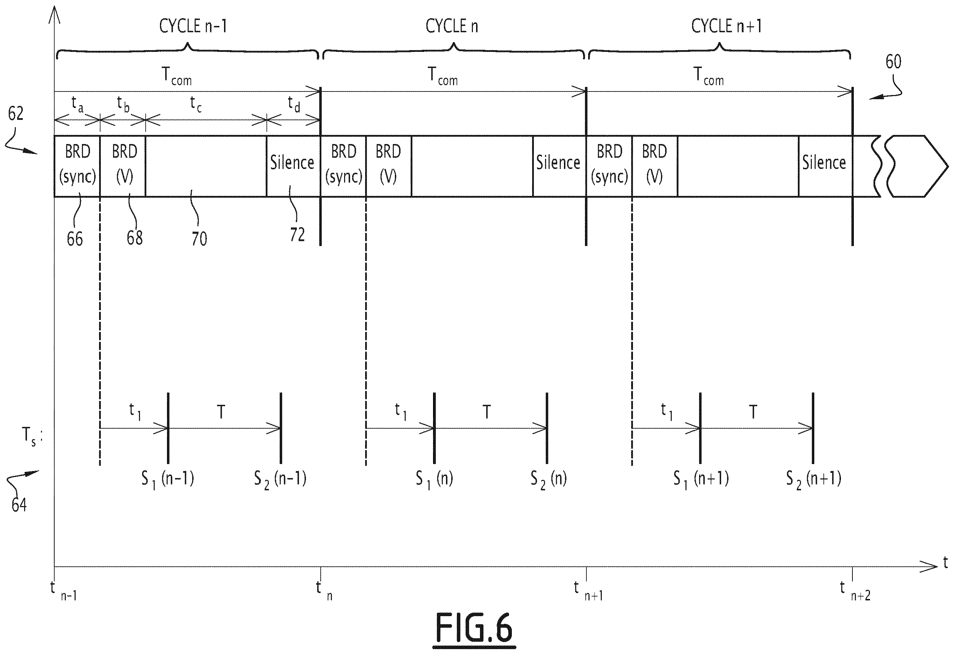

Dans le chronogramme 60 représenté sur la figure 6, le diagramme 62 représente le trafic de données échangées sur le bus de données 10 au cours du fonctionnement du système 2, notamment pendant trois périodes d'émission consécutives.

Par exemple, un cycle de communication entre les modules 4, 6 et 8 sur le bus de données 10 est défini pour chaque période d'émission T_{com}. Trois cycles de communication illustrés à des fins d'exemple sont ici notés « cycle n-1 », « cycle n » et « cycle n+1 », où « n » est un entier non nul. L'axe des abscisses représente une ligne des temps « t » et indique des instants tₙ₋₁, tₙ, tₙ₊₁, et tₙ₊₂. Les instants tₙ₋₁, tₙ, tₙ₊₁, correspondent, respectivement, au début des cycles n-1, n et n+1 et l'instant tₙ₊₂ correspond à la fin du cycle n+1.

Chaque cycle débute par l'émission du message de synchronisation, qui porte ici la référence 66. Par exemple, le message de synchronisation inclut une trame (« BRD (sync) ») qui est transmise par diffusion (« broadcast » en anglais) à tous les modules 6, 8 connectés au bus 10. Le message de synchronisation 66 présente ici une durée notée tₐ.

A titre d'exemple non nécessairement limitatif, pour chaque cycle, le message de synchronisation 66 est suivi immédiatement par un message 68 émis par le ou chaque module 6 et contenant une ou plusieurs valeurs de tension mesurée par le module 6. Par exemple, le message 68 comporte une trame de données (« BRD (V) ») qui contient une valeur de tension mesurée par ce module 6 lors du cycle précédent. Le message 68 présente ici une durée notée t_{b}.

Le message 68 est suivi par une plage 70 de durée notée t_{c} pendant laquelle les modules 6, 8 peuvent transmettre des données sur le bus de données 10.

La plage 70 est suivie par une période de silence 72 de durée notée t_{d} et qui marque la fin du cycle. Par exemple, pendant la période de silence 72, les modules 6 et 8 sont empêchés de transmettre des données sur le bus de données 10. Cela évite ainsi que la transmission du message de synchronisation 66 suivant soit entravée par la présence d'autres messages sur le bus de données 10 au moment de son émission.

Ainsi, la somme des durées tₐ, t_{b}, t_{c} et t_{d} est égale à la durée de la période d'émission T_{com}.

Selon des variantes non illustrées, le protocole de communication utilisé par les modules 4, 6, 8 pour communiquer sur le bus de données 10 peut être différent, de sorte que l'ordonnancement et/ou le type des données échangées sur le bus 10 après l'émission du message 66 peuvent être définis différemment.

Par exemple, les messages 68 peuvent être envoyés par le module 6 immédiatement après chaque mesure, sans forcément attendre le cycle suivant. Ainsi, plusieurs messages 68 peuvent être envoyés pendant chaque cycle de communication, chaque message 68 contenant le ou les valeurs de tension mesurées pour l'instant de mesure immédiatement précédent.

Selon des variantes, les périodes de silence 72 peuvent être omises.

La ligne 64 du chronogramme 60 représente des instants auxquels sont réalisées des mesures de grandeur électrique par un des modules de mesure 6, 8. Par exemple, la référence S₁(n-1) indique l'instant auquel une première mesure est réalisée par ce module de mesure 6, 8 pendant le cycle n-1. La référence S₂(n-1) indique l'instant auquel, le cas échéant, une deuxième mesure est réalisée par ce même module 6, 8 pendant le cycle n-1. La référence S₁(n) indique l'instant auquel une première mesure est réalisée pendant le cycle n. Et ainsi de suite.

La durée d'attente t₁ est ici décomptée par le premier compteur 50, dont la valeur courante est représentée par la durée « Tₛ ».

En pratique, la première horloge 38 est choisie pour ne pas présenter de dérive significative pendant une ou plusieurs répétitions de la période T_{com}.

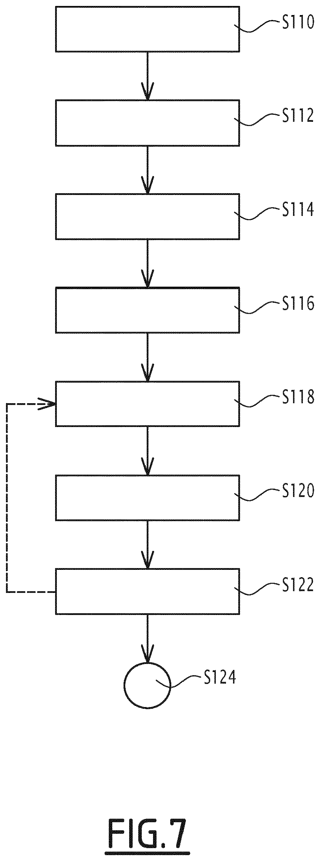

Comme illustré par la figure 7, lorsqu'un des deuxièmes modules 6, 8 reçoit un message de synchronisation 66 (étape S110), le premier compteur 50 est déclenché (étape S112) et, au moyen de l'horloge 48, le temps est compté jusqu'à atteindre la première durée d'attente t₁. La première durée d'attente t₁ a une valeur prédéfinie, par exemple enregistrée dans le support de stockage 44.

Une fois que la première durée d'attente t₁ est atteinte (étape S114), le module de mesure 6, 8 mesure une valeur S₁(n-1) de la grandeur électrique au moyen du capteur 56 (étape S116), par exemple par échantillonnage au moyen de l'interface d'acquisition 54. Par exemple, la valeur S₁(n-1) mesurée est ensuite stockée dans la mémoire 42 et/ou dans le support 44.

Selon des variantes, le module de mesure 6, 8 est programmé pour mesurer plusieurs valeurs de la grandeur électrique lors de chaque cycle de communication. Le procédé comporte alors en outre, pour chacun desdits modules de mesure 6, 8 :
- à la fin de la mesure de la grandeur électrique, le décompte d'une deuxième durée d'attente T, en utilisant la deuxième horloge 48 correspondante, par exemple au moyen du premier compteur 50 ;
- mesurer à nouveau la grandeur électrique, lors d'une mesure additionnelle, au moyen du capteur 56 correspondant, à la fin du décompte de la deuxième durée d'attente T.

Ainsi, une fois que la première valeur S₁(n-1) a été mesurée, le compteur 50 décompte la deuxième durée d'attente T (étape S118), de façon analogue à l'étape S112. Par exemple, le compteur 50 est réinitialisé au début de l'étape S118. Dans ces modes de réalisation, la valeur de la deuxième durée d'attente T est prédéfinie, par exemple stockée dans le support 44.

Une fois que la deuxième durée d'attente T est atteinte (étape S120), le module de mesure 6, 8 mesure une deuxième valeur S₂(n-1) de la grandeur électrique au moyen du capteur 56 (étape S122), de façon analogue à l'étape S116.

Les étapes S118, S120 et S122 peuvent être répétées autant de fois que nécessaire lorsque le module de mesure 6, 8 doit mesurer plus de deux fois la grandeur électrique lors de chaque cycle. Dans le cas contraire, le procédé prend fin à l'étape S124 après la deuxième mesure.

Par exemple, le nombre « p » de mesures de la grandeur électrique par un module 6, 8 pendant chaque cycle est supérieur ou égal à 1. Dans l'exemple illustré, le nombre de mesures « p » est égal à 2 pour chaque cycle.

En pratique, la période d'émission T_{com} est choisie en fonction du nombre de mesures et de la valeur de la deuxième durée d'attente T de manière à ce que les mesures soient terminées à la fin de chaque cycle.

On comprend que, dans le cas où le nombre de mesures p est égal à 1, les étapes S118 à S122 sont omises.

Par exemple, le procédé de la figure 7 est mis en œuvre par chacun des deuxièmes modules 6, 8 dès réception d'un message de synchronisation 66. Les étapes S110 à S116 et, le cas échéant, S118 à S122, sont alors répétées dès réception du message de synchronisation suivant lors du cycle suivant.

On comprend que les mesures additionnelles S₂(n-1), S₂(n), S₂(n+1), ... ne sont pas directement déclenchées par la réception du message de synchronisation 66, mais dépendent du décompte de la deuxième durée d'attente par la deuxième horloge. En pratique, les deuxièmes horloges 48 sont choisie pour ne pas présenter de dérive significative pendant une ou plusieurs répétitions de la deuxième durée d'attente T.

En variante, le procédé de la figure 7, lorsque mis en œuvre par le premier module de mesure 6, peut en outre comporter une étape, non illustrée, d'émission du message 68 précédemment décrit, ce message 68 comportant une valeur de tension précédemment mesurée par ce premier module de mesure 6, par exemple mesurée lors du cycle précédent.

Le procédé de la figure 7 est décrit en référence à un seul module 6, 8. On comprend toutefois que ce procédé est mis en œuvre indépendamment par chaque module 6, 8 dès réception d'un message de synchronisation.

Selon encore d'autres variantes optionnelles et non illustrées, une ou plusieurs étapes supplémentaires peuvent être mises en œuvre pour calculer une grandeur électrique composite à partir d'une ou plusieurs des grandeurs mesurées. Par exemple, une valeur de la grandeur électrique composite est calculée, pour chaque cycle, à partir d'une ou plusieurs des grandeurs électriques mesurées par des modules de mesure 6, 8. Selon un exemple, la grandeur électrique composite est une puissance électrique. Le calcul est, par exemple, mis en œuvre par les modules 6, 8 eux-mêmes ou par une unité de traitement dédiée, non illustrée, connectée au bus de données 10 et implémentée par un circuit électronique.

Par exemple, cette puissance est calculée par chaque deuxième module de mesure 8 à partir de la valeur de tension mesurée par le premier module de mesure 6 et transmise dans le message 68 et à partir des valeurs de courant mesurées par ce module de mesure 8.

Les modes de mise en œuvre de l'invention ci-décrits permettent ainsi de synchroniser la mesure des grandeurs électriques entre les différents modules de mesure 6, 8 du système de mesure 2. Les grandeurs électriques peuvent ainsi être mesurées simultanément par les modules de mesure 6, 8 du système 2, ou quasi-simultanément. Par « quasi simultanément », on désigne ici des mesures réalisées pendant une fenêtre temporelle de durée inférieure ou égale à 50µs.

Un tel procédé est plus avantageux qu'une synchronisation artificielle basée sur un recalage temporel effectué a posteriori à partir du déphasage calculé entre les mesures de tension et de courant, c'est-à-dire après que les mesures aient été effectuées par les modules de mesure.

En effet, un tel recalage n'est pas toujours satisfaisant, car typiquement le déphasage doit être déterminé en prenant comme référence des valeurs spécifiques de la tension et du courant parmi les valeurs mesurées, par exemple en prenant comme référence le passage par zéro du courant et de la tension. Une telle détermination du déphasage est fréquemment faussée par la présence d'harmoniques dans les grandeurs mesurées, et/ou par des déformations des signaux de courant et/ou de tension résultant d'un filtrage amont de ces signaux. Un tel filtrage est souvent imposé par les normes de compatibilité électromagnétique.

Par ailleurs, un mécanisme de synchronisation externe visant à recaler régulièrement les horloges locales des modules de mesure sur une horloge de référence externe consommerait trop de bande passante, encombrerait le bus de données et serait complexe à implémenter, notamment du fait qu'il nécessiterait des horloges locales plus sophistiquées et donc plus coûteuses.

Les modes de mise en œuvre de l'invention permettent de synchroniser les modules de mesure de façon simple et fiable, ce qui est avantageux notamment dans des applications où les modules de mesure 6, 8 doivent être peu coûteux à fabriquer et à entretenir et doivent fonctionner avec des ressources de calcul limitées, par exemple dans des applications où les modules de mesure 6, 8 doivent être déployés en masse dans des installations électriques 20 de grande taille.

En particulier, comme les deuxièmes horloges 48 n'ont pas besoin d'être aussi précises que la première horloge 38, le coût de fabrication des modules de mesure 6, 8 s'en trouve réduit.

Lorsque plusieurs mesures sont mises en œuvre pour chaque cycle de communication, il n'est pas nécessaire de synchroniser chaque module de mesure 6, 8 avant chaque mesure, puisque les modules de mesure 6, 8 se basent sur la deuxième durée d'attente pour déterminer quand effectuer la mesure. La synchronisation est donc indirecte.

Même si les deuxièmes horloges 48 sont relativement peu précises, le fait que les modules de mesure 6, 8 soient resynchronisés régulièrement, par exemple lors de chaque cycle, soit après p mesures, permet de maintenir une synchronisation satisfaisante des mesures additionnelles.

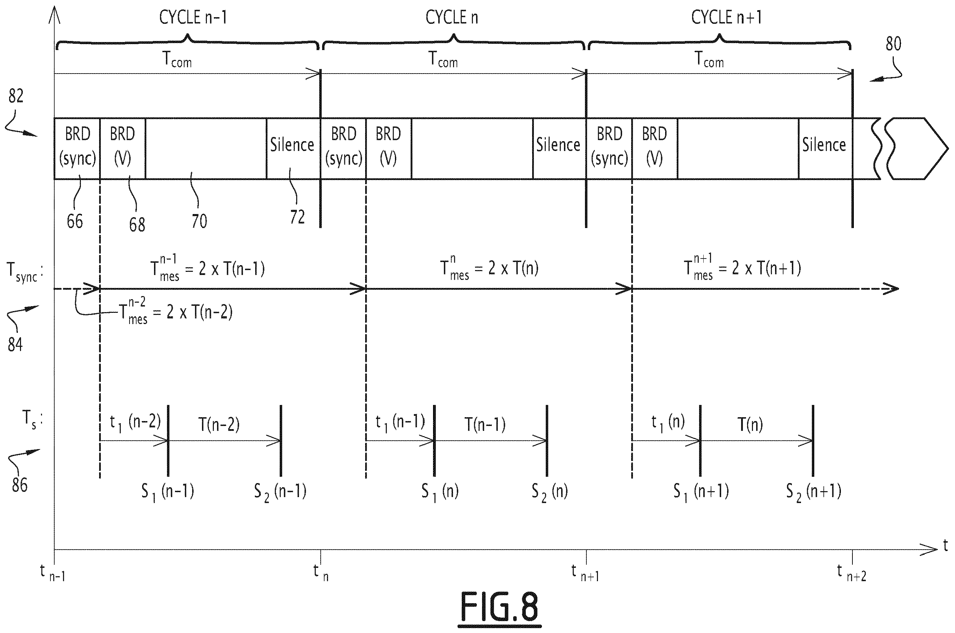

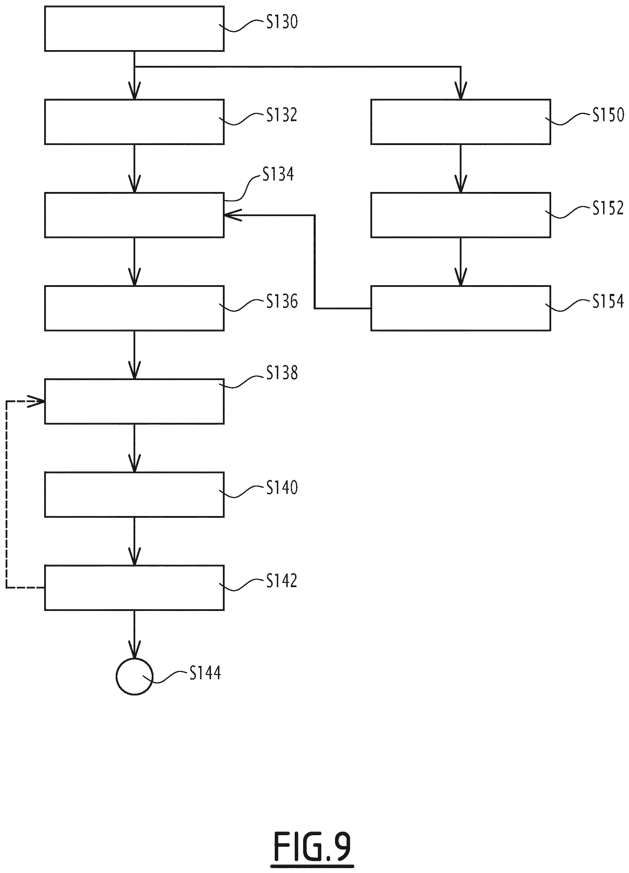

Des exemples de fonctionnement du système 2 selon des deuxièmes modes de réalisation sont maintenant décrits en référence aux figures 8 et 9.

Les deuxièmes modes de réalisation sont analogues aux premiers modes de réalisation décrits ci-dessus, et en diffèrent notamment par le fait que :
- le procédé comporte en outre, pour chacun desdits modules de mesure 6, 8 ayant reçu le message de synchronisation, la mesure de l'intervalle de temps Tₘₑₛ séparant la réception de deux messages de synchronisation 66 consécutifs par ce module de mesure 6, 8, cette mesure étant réalisée par le module de mesure 6, 8 en utilisant sa deuxième horloge 48 ;
- et par le fait que la première durée d'attente t₁ et la deuxième durée d'attente T sont déterminées, pour ce module de mesure 6, 8, en fonction dudit intervalle de temps Tₘₑₛ précédemment mesuré par ce module de mesure 6, 8.

Mis à part ces différences, la description des premiers modes de réalisation est transposable à celle des deuxièmes modes de réalisation. En particulier, les mêmes références numériques désignent des éléments semblables ou identiques, dont la description n'est pas reprise en détail. Notamment, ces deuxièmes modes de réalisation sont aptes à être implémentés par un système de mesure 2 tel que décrit précédemment, les modules de mesure 6, 8 étant reprogrammés en conséquence.

Dans le chronogramme 80 représenté sur la figure 8, le diagramme 82 représente le trafic de données échangées sur le bus de données 10 au cours du fonctionnement du système 2, notamment pendant trois périodes d'émission consécutives, de façon similaire au diagramme 62 décrit ci-dessus. Toutefois, là aussi, d'autres protocoles de communication que celui ici décrit à titre d'exemple peuvent être envisagés.

La ligne 84 du chronogramme 80 représente des intervalles de temps Tₘₑₛ séparant la réception de deux messages de synchronisation 66 consécutifs par un même module de mesure 6, 8.

Par exemple, la référence Tⁿ⁻¹ₘₑₛ désigne la valeur de l'intervalle de temps Tₘₑₛ mesuré pendant le cycle n-1 entre la réception du message de synchronisation 66 marquant le début du cycle n-1 et la réception du message de synchronisation 66 marquant le début du cycle n.

Les intervalles de temps Tₘₑₛ sont ici décomptés par le deuxième compteur 52, dont la valeur courante est représentée par la durée « T_{sync} ». En pratique, les premier et deuxième compteurs 50, 52 peuvent fonctionner indépendamment l'un de l'autre.

Selon des exemples, les intervalles de temps Tₘₑₛ ont normalement la même durée que la période T_{com}, les éventuelles durées de mesure, de traitement et de propagation des messages sur le bus 10 étant considérées comme négligeables par rapport à la durée de la période T_{com}.

La ligne 86 du chronogramme 80 représente des instants auxquels sont réalisées des mesures de la grandeur électrique par un des modules de mesure 6, 8, de façon analogue à la ligne 64 du chronogramme 60.

Par ailleurs, la référence t₁(n-2) désigne la valeur particulière prise par la première durée d'attente t₁ pendant le cycle n-1 dont la valeur est calculée à l'issue du cycle n-2 précédant le cycle n-1. La référence t₁(n-1) désigne la valeur particulière prise par la première durée d'attente t₁ pendant le cycle n dont la valeur est calculée à l'issue du cycle n-1. De façon similaire, la référence T(n-2) désigne la valeur particulière prise par la deuxième durée d'attente T pendant le cycle n-1 dont la valeur est calculée à l'issue du cycle n-2. Et ainsi de suite.

Selon des modes de mise en œuvre, la première durée d'attente t₁ est déterminée, pour chacun des modules de mesure 6, 8, suite à chaque réception d'un message de synchronisation par ce module de mesure, à partir d'une formule de calcul prédéterminée étant fonction de la valeur de l'intervalle de temps Tₘₑₛ précédemment mesuré par ce module de mesure.

Par exemple, la première durée d'attente t₁ est proportionnelle à ladite valeur dudit intervalle de temps Tₘₑₛ avec un premier coefficient de proportionnalité prédéfini.

D'après un exemple, le premier coefficient de proportionnalité est égal à « a/p » où « a » est une valeur numérique, par exemple strictement inférieure à 1. Ainsi, pour chaque cycle de communication n, la première durée d'attente t₁(n-1) est égale au produit du coefficient a/p par la valeur particulière Tⁿ⁻¹ₘₑₛ de l'intervalle de temps Tₘₑₛ mesurée pendant le cycle précédent.

En variante, la première durée d'attente t₁ est calculée pour chaque cycle de communication non seulement en fonction de la valeur de l'intervalle de temps Tₘₑₛ précédemment mesuré mais aussi en fonction d'un historique de valeurs de la première durée d'attente t₁, c'est-à-dire de précédentes valeurs de la première durée d'attente t₁ mesurées pour un ou plusieurs cycles précédents. Par exemple, la valeur calculée de la première durée d'attente t₁ tient compte d'une moyenne des valeurs calculées des premières durées d'attente t₁ associées à un nombre prédéfini de cycle précédents. Par exemple, cet historique peut être enregistré en mémoire 42, 44 du module de mesure 6, 8 et peut être mis à jour lors de chaque cycle.

Selon d'autres variantes, le calcul de la première durée d'attente t₁ pour ce cycle peut tenir compte d'un historique de valeurs de l'intervalle de temps Tₘₑₛ mesurées pour des cycles antérieurs. Par exemple, cet historique peut être enregistré en mémoire 42 ou 44 du module de mesure 6, 8 et peut être mis à jour lors de chaque cycle.

Selon d'autres modes de réalisation, dans les cas où une ou plusieurs mesures additionnelles sont mises en œuvre, la deuxième durée d'attente T est déterminée, pour chacun desdits modules de mesure 6, 8, suite à chaque réception du message de synchronisation par ce module de mesure, à partir d'une formule de calcul prédéterminée étant fonction dudit intervalle de temps Tₘₑₛ précédemment mesuré par ce module de mesure.

Par exemple, la deuxième durée d'attente T est proportionnelle à ladite valeur dudit intervalle de temps Tₘₑₛ en fonction d'un deuxième coefficient de proportionnalité prédéfini. A titre d'exemple, le premier coefficient de proportionnalité est égal à « 1/p ». Ainsi, pour chaque cycle de communication n, la deuxième durée d'attente T(n-1) est égale au produit du coefficient 1/p par l'intervalle de temps Tⁿ⁻¹ₘₑₛ mesuré pendant le cycle précédent.

En variante, la deuxième durée d'attente T est calculée pour chaque cycle de communication non seulement en fonction de la valeur de l'intervalle de temps Tₘₑₛ précédemment mesuré mais aussi en fonction d'un historique de valeurs de la deuxième durée d'attente T, telle qu'une moyenne des valeurs calculées des deuxième durée d'attente T associées à un nombre prédéfini de cycle précédents. Par exemple, cet historique peut être enregistré en mémoire 42, 44 du module de mesure 6, 8 et peut être mis à jour lors de chaque cycle.

Comme illustré par la figure 9, lorsqu'un des deuxièmes modules 6, 8 reçoit un message de synchronisation 66 (étape S130), le premier compteur 50 est déclenché (étape S132) et, au moyen de l'horloge 48, le temps est compté jusqu'à atteindre la première durée d'attente t₁ définie pour ce cycle.

Une fois que la première durée d'attente t₁ est atteinte (étape S134), le module 6, 8 mesure une valeur S₁(n-1) de la grandeur électrique au moyen du capteur 56 (étape S136). Une fois que la première valeur S₁(n-1) a été mesurée, le compteur 50 décompte la deuxième durée d'attente T (étape S138). Par exemple, le compteur 50 est réinitialisé au début de l'étape S138. Une fois que la deuxième durée d'attente T est atteinte (étape S140), le module 6, 8 mesure une deuxième valeur S₂(n-1) de la grandeur électrique au moyen du capteur 56 (étape S142). Les étapes S138, S140 et S142 peuvent être répétées autant de fois que nécessaire lorsque le module de mesure 6, 8 doit mesurer plus de deux fois la grandeur électrique lors de chaque cycle. Dans le cas contraire, le procédé prend fin à l'étape S144 après la deuxième mesure.

Par exemple, les étapes S130 à S144 sont similaires aux étapes S110 à S124 précédemment décrites.

En parallèle, le deuxième compteur 52 mesure la durée séparant la réception de deux messages de synchronisation 66 consécutifs.

Par exemple, initialement, le deuxième compteur 52 a été démarré lors du cycle précédent et compte le temps s'écoulant depuis la réception du message de synchronisation au début de ce cycle précédent.

Dès réception à la réception du message de synchronisation 66, le module 6, 8 arrête le deuxième compteur 52 et enregistre la valeur courante de ce compteur comme étant égale à l'intervalle de temps Tₘₑₛ (étape S150).

Ensuite, le deuxième compteur 52 est remis à zéro puis redémarré (étape S152) et commence à décompter le temps qui s'écoule, par exemple jusqu'à la prochaine itération de l'étape S150 initiée par la réception du message de synchronisation 66 suivant.

Lors d'une étape S154, selon les cas, la valeur de la première durée d'attente t₁ et/ou de la deuxième durée d'attente T pour ce cycle est/sont calculées en fonction de l'intervalle de temps Tₘₑₛ ainsi mesuré. Les valeurs courantes de la première durée d'attente t₁ et/ou de la deuxième durée d'attente T enregistrées en mémoire du module 6, 8 sont mises à jour en conséquence.

Selon les modes de mise en œuvre, lors de cette étape S154, le calcul la valeur de la première durée d'attente t₁ et/ou de la deuxième durée d'attente T pour ce cycle peut tenir compte, comme expliqué précédemment, d'un historique de valeurs de la première durée d'attente t₁ et/ou de la deuxième durée d'attente T et/ou d'un historique de valeurs de l'intervalle de temps Tₘₑₛ.

Lorsque la première durée d'attente est calculée en fonction de l'intervalle de temps Tₘₑₛ ainsi mesuré, alors les étapes S150, S152 et S154 sont de préférence mises en œuvre avant l'étape S134, comme illustré sur la figure 9.

En pratique, selon les modes de réalisation, les valeurs des première et deuxième durées d'attente t₁ et T peuvent être recalculées pour chaque cycle en fonction dudit intervalle de temps Tₘₑₛ mesuré, comme dans l'exemple décrit ci-dessus. Toutefois, en variante, seule l'une ou l'autre des première et deuxième durées d'attente t₁ et T peuvent être recalculées pour chaque cycle en fonction dudit intervalle de temps Tₘₑₛ mesuré.

Les deuxièmes modes de réalisation décrits ci-dessus permettent avantageusement d'améliorer la synchronisation des mesures entre les différents modules de mesure 6, 8.

En effet, comme les première et deuxième durées d'attente t₁ et T sont calculées localement dans chaque module en fonction de l'intervalle de temps Tₘₑₛ, et que ces durées et intervalles sont mesurés par la même deuxième horloge 48 dudit module, on compense ainsi automatiquement une éventuelle dérive de ladite deuxième horloge 48.

Par exemple, si la fréquence d'oscillation de la deuxième horloge 48 d'un module de mesure 6, 8 ralentit anormalement par rapport à une horloge de référence, alors les durées mesurées par cette deuxième horloge 48 apparaîtront plus courtes qu'elles ne le sont réellement. Ainsi, l'intervalle de temps Tₘₑₛ mesuré par cette horloge 48 sera perçu comme étant plus court qu'il ne l'est réellement. Comme cet intervalle de temps est ensuite utilisé pour calculer la première durée d'attente t₁ et, le cas échéant, la deuxième durée d'attente T, alors les première et deuxième durées d'attente t₁ et T seront minorées en conséquence. Comme les première et deuxième durées d'attente t₁ et T sont ensuite mesurées par cette même horloge 48, l'erreur ainsi apportée sur le calcul des première et deuxième durées d'attente t₁ et T sera compensée par la dérive de l'horloge 48, de sorte que la première mesure, voire les mesures additionnelles, seront au final synchronisées avec les mesures des modules de mesure 6, 8.

Il est donc possible de mesurer les grandeurs électriques de façon synchronisée ou quasi-synchronisée, sans devoir remettre à jour régulièrement les deuxièmes horloges 48 et sans avoir besoin d'utiliser des deuxièmes horloges 48 très précises, qui seraient alors trop coûteuses.

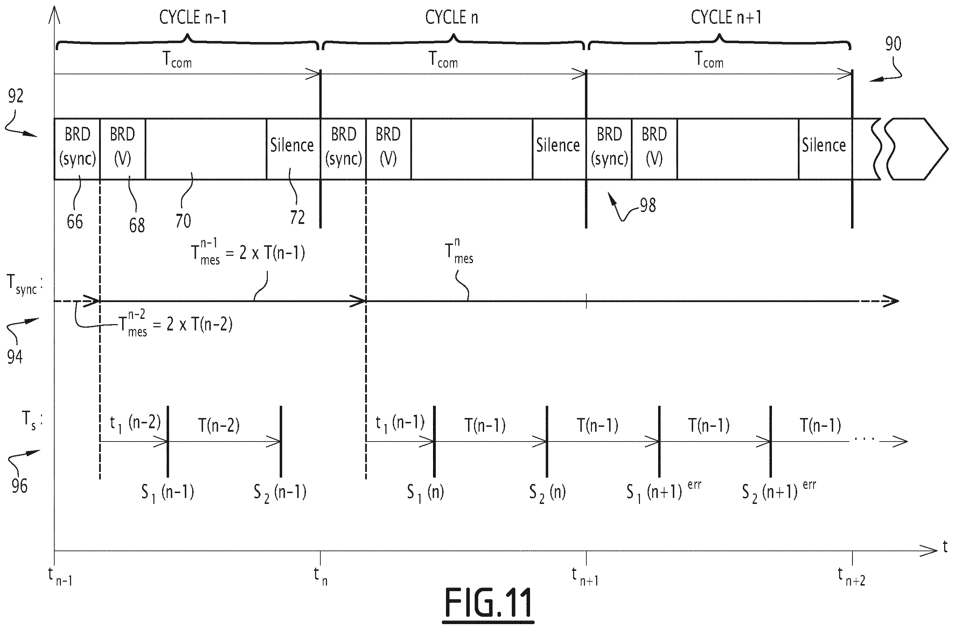

Des exemples de fonctionnement du système 2 selon des troisièmes modes de réalisation sont maintenant décrits en référence à la figure 11.

Les troisièmes modes de réalisation sont analogues aux premiers et deuxièmes modes de réalisation décrits ci-dessus, et en diffèrent notamment par le fait que, les mesures additionnelles sont répétées tant que le message de synchronisation suivant n'est pas reçu. On comprend donc que dans ce cas le nombre de mesures, noté p, est supérieur ou égal à deux.

Mis à part ces différences, la description des deuxièmes modes de réalisation est transposable à celle des troisièmes modes de réalisation. En particulier, les mêmes références numériques désignent des éléments semblables ou identiques, dont la description n'est pas reprise en détail. Notamment, ces troisièmes modes de réalisation sont aptes à être implémentés par un système de mesure 2 tel que décrit précédemment, les modules de mesure 6, 8 étant reprogrammés en conséquence.

Dans le chronogramme 90 représenté sur la figure 11, le diagramme 92 représente le trafic de données échangées sur le bus de données 10 au cours du fonctionnement du système 2, notamment pendant trois périodes d'émission consécutives, de façon similaire au diagramme 62 décrit ci-dessus. Toutefois, là aussi, d'autres protocoles de communication que celui ici décrit à titre d'exemple peuvent être envisagés.

La ligne 94 du chronogramme 90 représente des intervalles de temps Tₘₑₛ séparant la réception de deux messages de synchronisation 66 consécutifs par un même module de mesure 6, 8, de façon similaire à la ligne 84 du chronogramme 80.

La ligne 96 du chronogramme 90 représente des instants auxquels sont réalisées des mesures de la grandeur électrique par un des modules de mesure 6, 8, de façon analogue à la ligne 86 du chronogramme 60.

Les troisièmes modes de réalisation sont particulièrement applicables dans le cas où un des messages de synchronisation 66 n'est pas reçu par un module de mesure 6, 8, ou est reçu en retard. Dans l'exemple illustré, le message de synchronisation du cycle n+1 pointé par la référence 98 n'est pas reçu.

Ainsi, la mise en œuvre du procédé précédemment décrit à la Figure 9 est similaire, mis à part que les étapes S138, S140 et S142 mettant en œuvre les mesures additionnelles de la grandeur électrique continuent à être répétées jusqu'à réception d'un message de synchronisation 66.

Lorsque le message de synchronisation 66 est normalement reçu, comme cela est le cas à la fin du cycle n-1 dans l'exemple de la figure 11, cette répétition est interrompue et les étapes S132 et S150 sont normalement mises en œuvre ainsi que décrit précédemment. Notamment, le premier compteur 50 est réinitialisé pour décompter la première durée d'attente ti(n-1) et le deuxième compteur 52 est réinitialisé .

Cependant, le message de synchronisation 66 n'est pas reçu, comme cela est le cas au début du cycle n+1 dans l'exemple de la figure 11, les mesures de la grandeur électrique continuent à être mises en œuvre en se basant sur la deuxième durée d'attente T(n-1) calculée à partir du cycle précédent et non remise à jour, même lorsque le cycle n est en réalité terminé et que le cycle n+1 suivant a commencé. Ainsi, le module de mesure 6, 8 concerné n'est temporairement pas resynchronisé avec les autres modules de mesure 6, 8.

On note S₁(n+1)^{err} et S₂(n+1)^{err} les mesures des grandeurs électriques faites par ce module de mesure pendant le cycle n+1 alors que le module de mesure n'a pas été resynchronisé et continue à se baser sur la deuxième durée d'attente T(n-1) non remise à jour.

En parallèle, le deuxième compteur 52 continue à fonctionner, tant qu'aucun message de synchronisation 66 n'est reçu.

Par suite, lorsqu'un message de synchronisation 66 est à nouveau correctement reçu, l'étape S132 et, le cas échéant, l'étape S150 du procédé sont mises en œuvre comme précédemment décrit, ce qui permet de resynchroniser le module de mesure concerné avec les autres modules de mesure. Toutefois, cette valeur de l'intervalle de temps Tₘₑₛ calculée par le deuxième compteur 52 n'est de préférence pas prise en compte par la suite puisque n'étant pas représentative de l'intervalle entre l'émission de deux messages de synchronisation 66 consécutifs.

Par exemple, une valeur mesurée de l'intervalle de temps Tₘₑₛ est automatiquement rejetée si le nombre de mesures réalisé par le module de mesure 6, 8 pendant cet intervalle de temps Tₘₑₛ est différent d'un nombre prédéfini de mesures, par exemple supérieur au nombre maximal de mesures p.

Par « rejetée », on entend ici que cette valeur mesurée de l'intervalle de temps Tₘₑₛ n'est pas prise en compte par ce module de mesure pour calculer une valeur de la première durée d'attente t₁ ou de la deuxième durée d'attente T.

Par ailleurs, dans certaines variantes optionnelles, une erreur de synchronisation peut être détectée si un cycle se termine prématurément à cause de la réception prématurée d'un message de synchronisation, une telle erreur étant identifiée lorsque le nombre de mesures effectuées lors de ce cycle est mesuré comme étant inférieur au nombre de mesures p.

Les troisièmes modes de réalisation précédemment décrit permettent ainsi, en plus des autres avantages, d'assurer une continuité de fonctionnement du module de mesure sans fausser la synchronisation des mesures en cas de mauvaise réception ponctuelle du message de synchronisation. Le procédé de fonctionnement est ainsi plus robuste en cas d'erreur. Même si une éventuelle dérive de l'horloge locale 48 n'est temporairement plus compensée, cela se produit sur un nombre réduit d'intervalles de mesures, de sorte que l'impact sur la fiabilité des mesures reste maîtrisé.

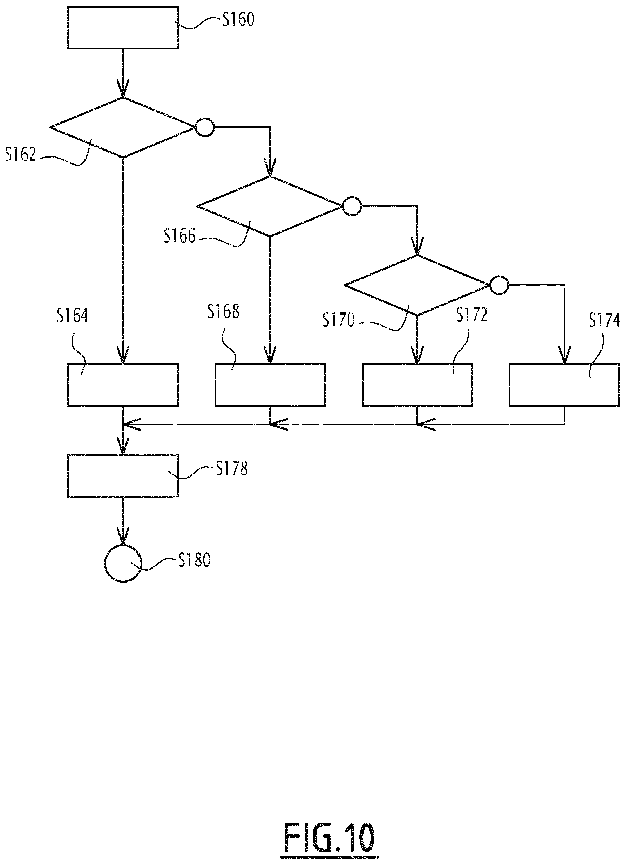

Un exemple de fonctionnement d'un module de mesure 6 ou 8 suite à son initialisation est maintenant décrit en référence à la figure 10.

Dans cet exemple, une variable première Nsync est définie comme indiquant l'état d'initialisation du module. Par exemple, la variable Nsync peut prendre plusieurs états prédéfinis : un premier état de démarrage, un deuxième état de démarrage et un état de fonctionnement normal.

Une deuxième variable Nmes est définie dont la valeur courante indique le nombre de mesures réalisé par ledit module 6 ou 8. Par exemple, les variables Nsync et Nmes sont stockées en mémoire 42.

Lorsque le module 6 ou 8 est démarré, il met en œuvre une séquence d'initialisation dans laquelle la variable Nsync est initialisée à une première valeur correspondant au premier état de démarrage. La variable Nmes est initialisée à zéro. La deuxième durée d'attente T est choisie égale à une valeur prédéfinie locale, par exemple préenregistrée en mémoire 42 ou 44. Le deuxième compteur 52 est déclenché. De même, la première durée d'attente t₁ est choisie égale à une valeur prédéfinie locale, par exemple préenregistrée en mémoire 42 ou 44, en vue de la prochaine réception du message de synchronisation 66.

Le module 6, 8 est alors dans un premier état de démarrage, dans lequel la mesure n'est pas synchronisée avec les autres modules de mesures et se base sur des durées d'attente définies localement. Une ou plusieurs mesures de la grandeur électrique peuvent alors être mises en œuvre lors d'étapes analogues aux étapes S142 à chaque expiration du premier compteur 52 à la fin de la deuxième durée T, la variable Nmes étant incrémentée lors de chaque mesure. Toutefois, cette situation changera lors de la réception du premier message de synchronisation 66.

Suite à la réception du message de synchronisation 66 (étape S160), la valeur de la variable Nsync est automatiquement vérifiée.

Si la valeur de la variable Nsync est déterminée comme correspondant au premier état de démarrage (étape S162), alors la valeur de la variable Nsync est changée au deuxième état de démarrage et les valeurs des première et deuxième durée d'attente t₁ et T prennent les valeurs prédéfinies (étape S164).

Puis les étapes S132 à S142 , telles que précédemment décrites, sont mises en œuvre avec les valeurs des première et deuxième durée d'attente t₁ et T ainsi définies, la variable Nmes étant incrémentée lors de chaque mesure de la grandeur électrique par le capteur 56 (étape S178). En d'autres termes, le module 6, 8 est dans un deuxième état de démarrage dans lequel la mesure est synchronisée avec les autres modules de mesures, mais dans laquelle l'horloge n'est pas corrigée. Le procédé se termine à l'étape S180, jusqu'à la réception du message de synchronisation suivant 66.

Si après l'étape S160 la valeur de la variable Nsync est déterminée comme correspondant au deuxième état de démarrage (étape S166), alors la valeur de la variable Nsync est changée à l'état de fonctionnement normal et les valeurs des première et deuxième durée d'attente t₁ et T sont calculées à partir de la valeur de l'intervalle de temps Tₘₑₛ mesurée (étape S168). Puis les étapes S132 et suivantes, telles que précédemment décrites, sont mises en œuvre avec les valeurs des première et deuxième durée d'attente t₁ et T ainsi calculées, la variable Nmes étant incrémentée lors de chaque mesure de la grandeur électrique par le capteur 56 (étape S178).

Par suite, le module de mesure 6, 8 est dans un mode de fonctionnement nominal dans lequel les mesures sont synchronisées et un éventuel décalage de l'horloge locale 48 est compensé. Par exemple, les étapes S132 et suivantes telles que décrites précédemment sont mises en œuvre.

Si suite à la réception d'un nouveau message de synchronisation 66 la variable Nsync n'est pas dans l'un des états de démarrage et le nombre de mesures Nmes est identifié comme égal au nombre de mesures p (étape S170), le module de mesure 6, 8 est considéré comme étant toujours dans un mode de fonctionnement nominal (étape S172). Dans le cas contraire (étape S174), si la variable Nmes a une valeur différente du nombre de mesures p, alors une erreur de synchronisation est considérée comme s'étant produite.

Par exemple, lorsqu'une erreur de synchronisation est considérée comme s'étant produite, alors une réinitialisation est mise en œuvre (étape S174), au cours de laquelle les valeurs des première et deuxième durée d'attente t₁ et T sont réinitialisées chacune à la valeur prédéfinie locale précédemment décrite. Le premier compteur 50 est réinitialisé avec la valeur prédéfinie locale de la première durée d'attente t₁ et le deuxième compteur 52 est réinitialisé pour débuter à nouveau le décompte de l'intervalle de temps Tₘₑₛ. La variable Nsync est réinitialisée au deuxième état de démarrage. Ainsi, la mesure continue à être réalisée de façon synchronisée, mais la compensation de la dérive de l'horloge locale 48 est temporairement inhibée, jusqu'à disposer de nouveau d'un intervalle de temps Tₘₑₛ représentatif de la durée T_{com} du cycle de communication.

De nombreux autres modes de réalisation sont possibles.

Dans certaines variantes optionnelles, la valeur de la première durée d'attente t₁ peut être ajustée localement pour chaque module de mesure 6, 8, pour tenir compte d'éventuels retards inhérents au circuit de mesure ou au bus de communication 10, de manière à favoriser une réception simultanée ou quasi-simultanée de chaque message de synchronisation 66 par tous les modules de mesure 6, 8.

Par exemple, dans le cas où les modules 4, 6, 8 sont connectés au bus de données 10 selon une topologie de type « daisy chain », les modules de mesure 6, 8 peuvent ne pas recevoir le message de synchronisation 66 en même temps, selon leur position sur le bus de données 10. Dans ce cas, la durée d'attente t₁ peut être ajustée localement pour chaque module de mesure 6, 8, pour tenir compte du temps que met le message de synchronisation à se propager de proche en proche entre les modules de mesure.

L'ajustement peut comporter l'ajout ou le retrait d'un délai prédéfini dans chaque module de mesure 6, 8, ce délai prédéfini étant propre à chaque module 6, 8. Par exemple, le délai prédéfini est calculé sur la base des spécifications techniques du module 6, 8 et/ou du bus de données 10, ou déterminé après étalonnage. Le délai prédéfini est par exemple enregistré en mémoire du module 6, 8.

Selon des exemples, dans les modes de réalisation où la première durée d'attente t₁ est prédéfinie et n'est pas calculée en fonction de l'intervalle de temps Tₘₑₛ, l'ajustement peut être réalisé lors de la fabrication ou de l'installation du système 2 en choisissant directement une valeur de la première durée d'attente t₁ qui tienne compte d'éventuels retards préalablement quantifiés. Dans les modes de réalisation où la première durée d'attente t₁ est automatiquement recalculée pour chaque cycle de communication en fonction de l'intervalle de temps Tₘₑₛ, l'ajustement pouvant être réalisé lors de l'étape S152 ou de l'étape S154, en ajoutant ou retranchant le délai prédéfini.

Plus généralement, dans les modes de mise en œuvre exposés ci-dessus, l'envoi du message de synchronisation 66 est réalisé périodiquement. La période d'émission T_{com} présente une valeur fixe, par exemple prédéfinie à l'avance.

Toutefois, selon des variantes, le message de synchronisation 66 n'est pas émis périodiquement et l'envoi du message de synchronisation 66 est réalisé avec un cycle d'émission de durée T_{com} variable.

Cette variation peut être connue à l'avance, c'est-à-dire que la période d'émission T_{com} peut, à chaque cycle, prendre une valeur choisie parmi une pluralité de valeurs prédéfinies. Par exemple, la période d'émission T_{com} alterne entre une première durée et une deuxième durée plus longue que la première durée.

De préférence, lorsque l'émission du message de synchronisation 66 n'est pas périodique, le message de synchronisation 66 envoyé par le module 4 comprend des données relatives au temps, ces données incluant par exemple une valeur de la première durée d'attente t₁ indiquant la durée d'attente avant la première mesure à effectuer au cours du cycle

Dans des modes de réalisation, dès réception du message de synchronisation 66, le premier compteur 50 est mis à jour avec la valeur reçue de la première durée d'attente t₁.

De préférence, la valeur de la première durée d'attente t₁ figurant dans le message de synchronisation 66 est calculée par le module 4. En plus, lorsqu'une synchronisation des horloges est mise en œuvre, par exemple d'une façon similaire à celle du procédé décrit aux figures 9 et 11, alors les données de temps contenues dans le message de synchronisation 66 peuvent en outre comporter la valeur de la durée T_{cyc} écoulée depuis l'envoi du dernier message de synchronisation 66 par le module 4. Par exemple, la durée T_{cyc} indique la durée du cycle de communication qui vient de se terminer. Ainsi, l'étape S154 peut être modifiée pour calculer différemment les valeurs de la première durée d'attente t₁ et de la deuxième durée d'attente T.

Selon d'autres modes de réalisation alternatifs, le nombre de mesures réalisées par les modules 6, 8 n'est pas nécessairement le même lors de chaque cycle. En d'autres termes, le nombre de mesures peut varier d'un cycle à un autre.

Ces modes de réalisation alternatifs sont particulièrement applicables aux modes de réalisation dans lequel la période d'émission T_{com} n'est pas constante : puisque certains cycles sont plus longs que d'autres, plus de mesures peuvent être réalisées pendant ces cycles.

Dans ce cas, de préférence, le message de synchronisation 66 comporte des données relatives au temps, telles que décrites précédemment, incluant notamment une valeur de la première durée d'attente t₁ et/ou une valeur de la durée T_{cyc} écoulée depuis l'envoi du dernier message de synchronisation 66 par le module 4.

De préférence, le message de synchronisation 66 comporte également un indicateur du nombre de mesures effectuées depuis la dernière synchronisation par ledit module de mesure 6, 8.

Par exemple, le module de synchronisation 4 est programmé pour compter le nombre de mesures réalisées lors de chaque cycle par tout ou partie des modules de mesure 6, 8, puis pour inclure le nombre de mesures ainsi décompté dans le message de synchronisation marquant le début du cycle suivant.

Par exemple, ce décompte est avantageusement réalisé en comptant le nombre de valeurs mesurées incluses dans le message de données 68 envoyé, ou, pour les modes de réalisation dans lequel un tel message de données 68 est envoyé immédiatement après chaque mesure, en comptant le nombre de messages de données 68 émis lors de chaque cycle par un module 6, 8.

Lors de la mise en œuvre du procédé, la connaissance du nombre de mesures reçu dans le message de synchronisation 66 permet de détecter une anomalie de fonctionnement du module de mesure, par exemple pour déterminer qu'un message de synchronisation précédent n'a pas été reçu. Cette détermination peut être réalisée en comparant le nombre de mesures indiqué dans le message de synchronisation 66 reçu avec le nombre de mesures enregistré dans la variable Nmes.

Les modes de réalisation et les variantes envisagés ci-dessus peuvent être combinés entre eux pour donner naissance à de nouveaux modes de réalisation.

## Revendications

1. Procédé de mesure de grandeurs électriques, **caractérisé en ce que** ce procédé comporte :
- l'envoi d'un message de synchronisation (66) sur un bus de données (10), par un module de synchronisation (4) connecté au bus de données (10), l'envoi étant réalisé avec une période d'émission (T_{com}), la période d'émission étant décomptée à l'aide d'une première horloge (38) du module de synchronisation ;
- la réception du message de synchronisation, par des modules de mesure (6, 8) connectés au bus de données (10), chaque module de mesure comportant un capteur (56) adapté pour mesurer une grandeur électrique, chaque module de mesure comportant également une deuxième horloge (48) ;
- le décompte, par chaque module de mesure (6, 8) ayant reçu le message de synchronisation, d'une première durée d'attente (t₁), le décompte étant réalisé, pour chacun desdits modules de mesure, en utilisant la deuxième horloge (48) appartenant à ce module de mesure ;
- pour chacun desdits modules de mesure (6, 8), la mesure de la grandeur électrique au moyen du capteur (56) correspondant à la fin du décompte de la première durée d'attente (t₁).

2. Procédé de mesure selon la revendication 1, **caractérisé en ce que** le procédé comporte en outre, pour chacun desdits modules de mesure :
- à la fin de la mesure de la grandeur électrique, le décompte d'une deuxième durée d'attente (T), en utilisant la deuxième horloge correspondante ;
- mesurer à nouveau la grandeur électrique, lors d'une mesure additionnelle, au moyen du capteur correspondant, à la fin du décompte de la deuxième durée d'attente (T).

3. Procédé de mesure selon la revendication 1 ou la revendication 2, **caractérisé en ce que** le procédé comporte en outre, pour chacun desdits modules de mesure, la mesure de l'intervalle de temps (Tₘₑₛ) séparant la réception de deux messages de synchronisation (66) consécutifs par ce module de mesure (6, 8), cette mesure étant réalisée par le module de mesure en utilisant sa deuxième horloge (48), et **en ce que** la première durée d'attente (ti) est déterminée, pour ce module de mesure, en fonction dudit intervalle de temps (Tₘₑₛ) précédemment mesuré par ce module de mesure.

4. Procédé de mesure selon la revendication 3, **caractérisé en ce que** la première durée d'attente (ti) est déterminée, pour chacun desdits modules de mesure (6, 8), suite à chaque réception d'un message de synchronisation (66) par ce module de mesure, à partir d'une formule de calcul prédéterminée étant fonction de la valeur dudit intervalle de temps (Tₘₑₛ) précédemment mesuré par ce module de mesure, par exemple dans laquelle la première durée d'attente (ti) est proportionnelle à ladite valeur dudit intervalle de temps en fonction d'un premier coefficient de proportionnalité prédéfini.

5. Procédé de mesure selon l'une quelconque des revendications 2 à 4, **caractérisé en ce que** le procédé comporte la mesure de l'intervalle de temps (Tₘₑₛ) séparant la réception de deux messages de synchronisation (66) consécutifs par ce module de mesure (6, 8), cette mesure étant réalisée par le module de mesure en utilisant sa deuxième horloge (48) et **en ce que** la deuxième durée d'attente (T) est déterminée, pour chacun desdits modules de mesure (6, 8), en fonction dudit intervalle de temps (Tₘₑₛ) précédemment mesuré par ce module de mesure.

6. Procédé de mesure selon la revendication 5, **caractérisé en ce que** la deuxième durée d'attente (T) est déterminée, pour chacun desdits modules de mesure (6, 8), suite à chaque réception d'un message de synchronisation par ce module de mesure, à partir d'une formule de calcul prédéterminée étant fonction dudit intervalle de temps (Tₘₑₛ) précédemment mesuré par ce module de mesure, par exemple dans laquelle la deuxième durée d'attente (T) est proportionnelle à ladite valeur dudit intervalle de temps en fonction d'un deuxième coefficient de proportionnalité prédéfini.

7. Procédé de mesure selon l'une quelconque des revendications 2 à 6, **caractérisé en ce que** les mesures additionnelles sont répétées par le module de mesure (6, 8) tant que le message de synchronisation suivant n'est pas reçu par le module de mesure (6, 8).

8. Procédé de mesure selon l'une quelconque des revendications 3 à 7, **caractérisé en ce que** l'intervalle de temps (Tₘₑₛ) mesuré n'est pas pris en compte par le module de mesure (6, 8) lorsque le nombre de mesures effectuées par ce module de mesure pendant cet intervalle de temps est différent d'un nombre prédéfini de mesures.

9. Procédé de mesure selon l'une quelconque des revendications 2 à 8, **caractérisé en ce que** l'envoi du message de synchronisation (66) est réalisé périodiquement avec la période d'émission (T_{com}) prédéfinie.

10. Procédé de mesure selon l'une quelconque des revendications 2 à 8, **caractérisé en ce que** l'envoi du message de synchronisation (66) est réalisé avec un cycle d'émission de durée (T_{com}) variable.

11. Procédé de mesure selon l'une quelconque des revendications précédentes, **caractérisé en ce que** les modules de mesure (6, 8) sont associés à des conducteurs électriques d'une installation électrique (20), au moins un des modules de mesure (6) étant configuré pour mesurer une tension électrique, au moins une pluralité des autres modules de mesure (8) étant configurés pour mesurer une intensité d'un courant électrique.

12. Système de mesure (2) de grandeurs électriques, comportant :
- un module de synchronisation (4), comportant une première horloge (38) ;
- des modules de mesure (6, 8), chaque module de mesure comportant un capteur (56) adapté pour mesurer une grandeur électrique, chaque module de mesure comportant également une deuxième horloge (48),
- un bus de données (10), le module de synchronisation et les modules de mesure étant connectés au bus de données,
en ce que le module de synchronisation (4) est configuré pour envoyer périodiquement un message de synchronisation (66) sur le bus de données, avec une période d'émission (T_{com}) prédéfinie, la période d'émission étant décomptée à l'aide de la première horloge (38) ;
et en ce que chaque module de mesure (6, 8) est configuré pour :
- recevoir des messages de synchronisation (66),
- après chaque réception d'un message de synchronisation, décompter une première durée d'attente (t₁), le décompte étant réalisé, pour chacun desdits modules de mesure (6, 8), en utilisant la deuxième horloge (48) appartenant à ce module de mesure ;
- mesurer la grandeur électrique au moyen du capteur correspondant (56) à la fin du décompte de la première durée d'attente.

13. Système de mesure (2) selon la revendication 12, **caractérisé en ce que** chaque module de mesure (6, 8) est en outre configuré pour :
- à la fin de la mesure de la grandeur électrique, décompter une deuxième durée d'attente (T), en utilisant la deuxième horloge correspondante ;
- mesurer à nouveau la grandeur électrique, lors d'une mesure additionnelle, au moyen du capteur correspondant, à la fin du décompte de la deuxième durée d'attente (T).

14. Système de mesure (2) selon la revendication 13, **caractérisé en ce que** chaque module de mesure (6, 8) est en outre configuré pour répéter les mesures additionnelles tant que le message de synchronisation suivant n'est pas reçu par le module de mesure (6, 8).
